# EUROPÄISCHE PATENTSCHRIFT

(11) **EP 0 316 881 B1**
(45) Veröffentlichungstag und Bekanntmachung des Hinweises auf die Patenterteilung: **07.09.1994**
(21) Anmeldenummer: 88119042.5
(22) Anmeldetag: 15.11.1988
(51) Int. Cl.: H01L 29/743, H01L 29/08, H01L 29/32, H01L 31/111, H01L 21/324

(54) **Thyristor mit einstellbarer Kippspannung**
Thyristor with adjustable break-over voltage
Thyristor à tension de retournement ajustable

(30) Priorität: 20.11.1987 DE 3739394
(43) Veröffentlichungstag der Anmeldung: 24.05.1989
(60) Teilanmeldung: 93109037.7
(73) Patentinhaber: SIEMENS AKTIENGESELLSCHAFT, 80333 München (DE)
(72) Erfinder: Schulze, Hans-Joachim, Dr. Dipl.-Phys., D-8011 Anzing (DE); Mitlehner, Heinz, Dr. Dipl.-Phys., D-8000 München 40 (DE)

(56) Entgegenhaltungen:
- EP-A- 0 154 082
- EP-A- 0 197 512
- DE-A- 2 747 945
- US-A- 4 165 517
- SOLID-STATE ELECTRONICS, vol. 17, pp. 655-661 (1974).
- W. GERLACH, Thyristoren (Halbleiter-Elektronik, Band 12) (Springer-Verlag, Berlin, Heidelberg, New York, 1979), Seiten 64-65.

## Beschreibung

Die Erfindung bezieht sich auf einen Thyristor nach dem Oberbegriff des Patentanspruchs 1.

Wird bei einem Thyristor eine zwischen seiner kathodenseitigen und anodenseitigen Elektrode angelegte, den Thyristor blockierende Spannung auf den Wert der sog. Kippspannung (break over voltage) erhöht, so erfolgt ein lokaler Durchbruch des pn-Ubergangs, der die p-Basis von der n-Basis trennt und etwa parallel zu einer Hauptfläche des Halbleiterkörpers verläuft. Im allgemeinen tritt der Durchbruch an dem in der Seitenfläche des Thyristors liegenden Rand dieses pn-Übergangs auf. Zur Vermeidung eines solchen unkontrollierbaren und sehr oft zur Zerstörung des Thyristors führenden lokalen Durchbruchs ist es aus der EP-A-0 088 967 bekannt, den pn-Übergang zwischen der p-Basis und der n-Basis durch Bestrahlung mit einem Laserstrahl unterhalb des zentralen Zündkontakts des Thyristors mit einer die Dicke der n-Basisschicht verringernden Ausbuchtung zu versehen und damit bereits bei einer reduzierten Kippspannung einen kontrollierbaren Durchbruch herbeizuführen, der im Bereich der Ausbuchtung auftritt. Dieser kontrollierbare Durchbruch führt zu einer Überkopfzündung des Thyristors, bei der eine thermische Zerstörung wegen der reduzierten Kippspannung nicht eintritt. Nachteilig ist jedoch, daß die reduzierte Kippspannung hierbei nicht mit der gewünschten Genauigkeit und Reproduzierbarkeit auf einen bestimmten Spannungswert eingestellt werden kann.

Aus der Veröffentlichung von Peter Voss mit dem Titel "A Thyristor protected against di/dt-failure at breakover turn-on", Solid-State Electronics, 1974, Vol. 17, pp. 655 - 661, Pergamon Press, ist die Einstellung der Kippspannung eines Thyristor mit Hilfe einer lokalen Erhöhung der Dotierung in der n-Basis bekannt, bei dem ein Ausgangsmaterial mit einem entsprechenden Dotierungsprofil verwendet wird und bei dem die Feldstärke in der n-Basis lokal verändert wird. Ferner ist hieraus eine weitere Möglichkeit zur Beeinflussung der Kippspannung bekannt, die auf der Anderung der Stromverstärkung des npn-Transistors im Thyristor beruht, die durch die allgemein verwendete Technik der verkürzten n-Emitter bewirkt wird.

Aus der europäischen Patentanmeldung mit der Veröffentlichungsnummer EP-A-0 154 082 ist ein Gate turn-off- Thyristor bekannt, der einen Teilbereich des p-Emitters aufweist, der im lateralen Bereich eines Zündkontakts angeordnet ist und eine höhere Dotierungskonzentration aufweist als die übrigen Teile des p-Emitters. Die Dotierungskonzentration in den übrigen Teilen des p-Emitters, wie beispielsweise im lateralen Bereich der Kathodenelektrode, ist gegenüber einer Grunddotierungskonzentration eines p-Emitters reduziert, um eine Stromkonzentration in den übrigen Teilen des p-Emitters zu vermeiden.

Der Erfindung liegt nun die Aufgabe zugrunde, einen Thyristor der eingangs genannten Art anzugeben, bei dem der pn-Übergang zwischen der p-Basis und der n-Basis beim Erreichen einer in einfacher Weise einstellbaren, reduzierten Kippspannung in definierter Weise durchbricht, ohne daß hierdruch eine thermische Zerstörung eintritt. Das wird erfindungsgemäß durch eine Ausbildung nach dem kennzeichnenden Teil des Patentanspruchs 1 erreicht.

Der mit der Erfindung erzielbare Vorteil liegt insbesondere darin, daß eine reduzierte Kippspannung, bei der der pn-Übergang zwischen der p-Basis und der n-Basis des Thyristors durchbricht, ohne daß dieser hierdurch Schaden erleidet, mit hinreichender Genauigkeit und Reproduzierbarkeit eingestellt werden kann.

Der Anspruch 2 ist auf eine bevorzugte Weiterbildung der Erfindung gerichtet. Die Ansprüche 3 bis 5 geben bevorzugte Verfahren zur Herstellung eines erfindungsgemäßen Thyristors an.

Die Erfindung wird nachfolgend anhand der Zeichnung näher erläutert. Dabei zeigen:
- Fig. 1: ein erstes Ausführungsbeispiel der Erfindung und
- Fig. 2: ein zweites Ausführungsbeispiel, während

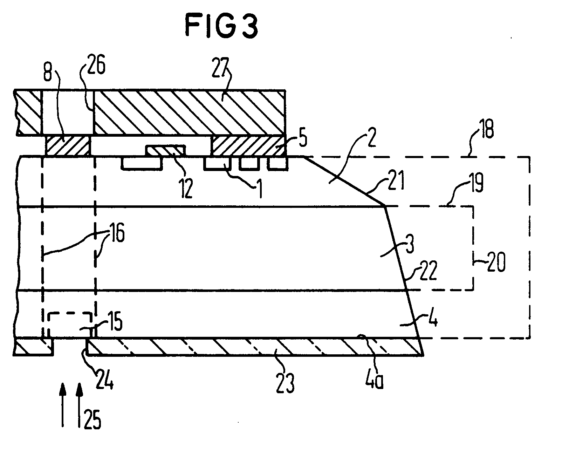

- Fig. 3: ein bevorzugtes Verfahren zur Herstellung eines Thyristors nach Fig. 1 oder 2 näher erläutert.

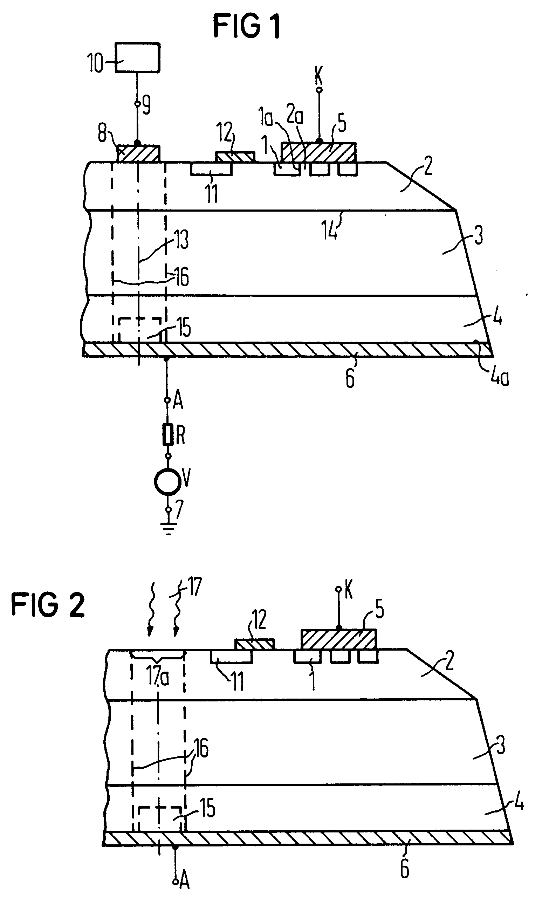

Fig. 1 zeigt einen Leistungsthyristor, der einen dotierten Halbleiterkörper mit vier aufeinanderfolgenden Halbleiterschichten alternierender Leitfähigkeitstypen aufweist. Im einzelnen bestehen diese aus einem n-Emitter 1, einer p-Basis 2, einer n-Basis 3 und einem p-Emitter 4. Der n-Emitter 1 wird von einer mit einem Anschluß K versehenen, kathodenseitigen Elektrode 5 kontaktiert, der p-Emitter 4 von einer anodenseitigen Elektrode 6, die mit einem Anschluß A versehen ist. Ein bei A angeschlossener äußerer Stromkreis besteht aus einem Arbeitswiderstand R und einer in Serie zu diesem liegenden Spannungsquelle V, die z.B. eine Gleichspannung von 1000 Volt abgibt. Der nicht mit R beschaltete Anschluß der Spannungsquelle V, der mit 7 bezeichnet ist, liegt ebenso wie der Anschluß K auf Bezugspotential. Dabei wird die anodenseitige Elektrode 6 durch die von V gelieferte Spannung auf ein gegenüber K positives Potential gelegt, so daß sich der Thyristor im sog. blockierenden Zustand befindet.

Ein die p-Basis 2 kontaktierender Zündkontakt 8 ist mit einem Anschluß 9 versehen, dem aus einem mit 10 bezeichneten Zündstromkreis ein positiver Spannungsimpuls zugeführt wird, um den Thyristor zu zünden. Wird der sich im blockierenden Zustand befindende Thyristor durch die Zündung in den stromführenden Zustand übergeführt, so schließt er den äußeren, über A, R, V, 7 und K verlaufenden Stromkreis durch eine niederohmige Verbindung von K und A. Das Löschen des Thyristors, d.h. seine Überführung in den hochohmigen, nicht stromführenden Zustand erfolgt durch Abschaltung der Spannungsquelle V oder für den Fall, daß es sich bei V um eine Wechselspannungsquelle handelt, bei dem ersten nach der Zündung auftretenden Nulldurchgang der von V gelieferten Wechselspannung.

Ein in die p-Basis 2 eingefügtes n-leitendes Gebiet 11 ist mit einer leitenden Belegung 12 versehen, die in Richtung auf den n-Emitter 1 soweit verlängert ist, daß sie den pn-Übergang zwischen 11 und 2 kurzschließt. Die Teile 11 und 12 bilden dann einen sog. Hilfsemitter (amplifying gate), der eine innere Zündverstärkung des Thyristors darstellt. Bei rotationssymmetrischem Aufbau des Thyristors ist die strichpunktierte Linie 13 als Symmetrieachse anzusehen. Mit 1a sind Ausnehmungen des n-Emitters 1 bezeichnet, die von entsprechenden Ansätzen 2a der p-Basis 2 ausgefüllt werden. Letztere werden von der kathodenseitigen Elektrode 5 kontaktiert. Die Teile 1a und 2a bilden Emitter-Basis-Kurzschlüsse, die eine unerwünschte Zündung des Thyristors beim Anlegen von Blockierspannungen verhindern.

Zwischen der p-Basis 2 und der n-Basis 3 befindet sich ein pn-Übergang 14, der beim Anlegen einer Blockierspannung an die Anschlüsse A und K in Sperrichtung vorgespannt wird. Erhöht man die zwischen A und K liegende Blockierspannung auf den Wert der sog. Kippspannung, so führt der dann entstehende lokale Durchbruch des pn-Übergangs 14 zu einer unkontrollierbaren Zündung des Thyristors, die diesen thermisch zerstören kann.

Um diese Gefahr zu beseitigen, ist die Dotierungskonzentration des p-Emitters 4 innerhalb eines Teilbereichs 15 höher bemessen als in dem übrigen Teil des p-Emitters 4. Dabei liegt der Teilbereich 15 etwa unterhalb des Zündkontakts 8 bzw. bei konzentrischer Ausbildung des Thyristors im Bereich der Symmetrieachse 13, um eine möglichst schnelle Zündausbreitung zu gewährleisten. In Fig. 1 geht der Teilbereich 15 unmittelbar von der äußeren, von der anodenseitigen Elektrode 6 kontaktierten Grenzfläche 4a des p-Emitters 4 aus und hat eine Eindringtiefe, die kleiner ist als die Eindringtiefe des p-Emitters 4. Andererseits kann die Eindringtiefe des Teilbereichs 15 auch der des p-Emitters 4 entsprechen. Weiterhin ist es auch möglich, daß der Teilbereich 15 des p-Emitters 4 nicht bis an die Grenzfläche 4a heranreicht, sondern durch eine Teilschicht des p-Emitters 4 von dieser getrennt ist. Dieser Fall könnte in Fig. 1 durch eine Vertikalverschiebung des gestrichelt eingezeichneten Teilbereichs 15 nach oben angedeutet werden. Nimmt man beispielsweise an, daß bei einer Anordnung des Teilbereichs 15 gemäß Fig. 1 die Dotierungskonzentration des p-Emitters 4 an der Grenzfläche 4a zur anodenseitigen Elektrode 6 etwa 10¹⁸cm⁻³ beträgt, so wäre zweckmäßigerweise ein entsprechender Wert von 10²⁰cm⁻³ für den Teilbereich 15 vorzusehen. Durch die Erhöhung der Dotierungskonzentration innerhalb des Teilbereichs 15 wird eine Erhöhung des für die Schichtfolge 2, 3 und 4 im Bereich der Symmetrieachse 13 maßgebenden Verstärkungsfaktors αₚₙₚ erreicht, was eine Verringerung der Kippspannung auf den Wert einer reduzierten Kippspannung zur Folge hat. Mit Vorteil erfolgt die Erhöhung der Dotierungskonzentration im Teilbereich 15 im Wege einer Ionenimplantation, der sich ein Temperschritt anschließt. Unter diesem wird eine Erwärmung des Halbleiterkörpers auf etwa 950° bis 1200°C für eine vorgegebene Zeitspanne von z.B. 30 Minuten bis 30 Stunden verstanden.

Die auf die beschriebene Weise eingestellte, reduzierte Kippspannung wird nach der Erfindung durch eine Bestrahlung des Halbleiterkörpers im Bereich des Zündkontakts 8 mit Elektronen oder Protonen in Richtung auf höhere Werte verschoben. Dies ist darauf zurückzuführen, daß im bestrahlten Bereich die Trägerlebensdauer und damit der Verstärkungsfaktor αₚₙₚ erniedrigt werden.

In Figur 1 ist der auf diese Weise bestrahlte, etwa zylindrische Bereich durch die gestrichelten Begrenzungslinien 16 angedeutet.

Nach erfolgter Bestrahlung des Bereichs 16 mit Elektronen oder Protonen kann der Betrag, um den die reduzierte Kippspannung in Richtung auf höhere Werte verschoben worden ist, noch durch Anwendung eines weiteren Temperschrittes korrigiert, d.h. geringfügig verkleinert werden. Ein solcher weiterer Temperschritt bedeutet, daß der Halbleiterkörper einer Temperatur von z.B. 250° bis 350°C über eine vorgegebene Zeitspanne von z.B. 30 Minuten bis 20 Stunden ausgesetzt wird, wodurch die Trägerlebensdauer im Bereich 16 wieder geringfügig erhöht wird. Diese Bestrahlung und der weitere Temperschritt bewirken dann eine vorteilhafte Feinjustierung der reduzierten Kippspannung.

In Figur 2 ist ein lichtzündbarer Thyristor dargestellt, bei dem anstelle der elektrischen Zündung mittels des Zündkontakts 8 eine Lichtzündung durch Bestrahlung einer etwa im Bereich der Symmetrieachse 13 liegenden lichtempfindlichen Thyristorzone 17a mit einem Lichtimpuls erfolgt. Der Lichtimpuls ist in Figur 2 mit 17 angedeutet. Zur Zuführung des Lichtimpulses wird im allgemeinen ein Lichtleiter verwendet, der insbesondere so ausgebildet sein kann, wie in der EP-A 0 197 512 im einzelnen beschrieben ist. Auch hier wird durch den Teilbereich 15 eine reduzierte Kippspannung eingestellt, die durch eine zusätzliche Bestrahlung eines sich von der lichtempfindlichen Thyristorzone in vertikaler Richtung bis zur anodenseitigen Elektrode 6 erstreckenden Bereichs 16 mit Elektronen oder Protonen in Richtung auf höhere Werte verschoben werden kann. Den Betrag dieser Verschiebung kann man wieder durch einen Temperschritt geringfügig verringern. Vorteilhaft wirkt es sich bei Anwendung dieses Prinzips auch aus, daß die Lichtempfindlichkeit durch den erhöhten Verstärkungsfaktor αₚₙₚ ohne wesentlichen Nachteil für das dU/dt-Verhalten gesteigert wird.

Bei der Herstellung eines erfindungsgemäßen Thyristors wird von einem schwach n-leitenden Halbleiterkörper 18 in Form einer flachen Scheibe ausgegangen, der in an sich bekannter Weise mit einer randseitigen p-Diffusionszone versehen wird, die sich bis zu den Linien 19 und 20 in den Halbleiterkörper hinein erstreckt . Nach dem Entfernen des Scheibenrandes bis auf die Seitenflächen 21 und 22 stellt der obere Teil der p-Diffusionszone die p-Basis 2 dar, während der untere Teil der p-Diffusionszone den p-Emitter 4 bildet. Nach dem Aufbringen einer Maske 23 aus SiO₂ oder lichtempfindlichem Lack wird auf fotolithografischem Wege ein Maskenfenster 24 vorgesehen, durch das in einem sich anschließenden, mit 25 angedeuteten Implantationsschritt Akzeptorionen mit einer Implantationsdosis von z.B. 10⁻¹⁶cm⁻² eingebracht werden. In dem folgenden Temperschritt entsteht dann der höher dotierte Teilbereich 15 der p-Basis 4. Die Bestrahlung des Bereichs 16 mit Elektronen oder Protonen wird in einem Korpuskularstrahlgerät vorgenommen, wobei eine mit einem Loch 26 versehene Maske 27 die Bestrahlung der außerhalb von 16 liegenden Thyristorteile verhindert. Von besonderem Vorteil ist es, daß diese Bestrahlung auch am fertigen Thyristor vorgenommen werden kann, der z.B. bereits mit den Belegungen bzw. Elektroden 8, 12, 5 und 6 versehen ist. Die Maske 27 kann auch aus einem im Betrieb auf die Elektrode 5 aufgesetzten, zur besseren Ableitung des Laststromes dienenden Druckkontakt bestehen. Auch die Korrektur der durch die Bestrahlung mit Elektronen oder Protonen vorgenommenen Verschiebung der Kippspannung mittels des genannten weiteren Temperschrittes kann am fertigen Thyristor erfolgen.

Bei einem Thyristor nach der Erfindung können die zur inneren Zündverstärkung dienenden Teile 11 und 12 auch entfallen.

## Patentansprüche

1. Thyristor mit einem Halbleiterkörper, der einen von einer kathodenseitigen Elektrode (5) konktaktierten n-Emitter (1) mit einer angrenzenden p-Basis (2) und einen von einer anodenseitigen Elektrode (6) kontaktierten p-Emitter (4) mit einer angrenzenden n-Basis (3) aufweist, die ihrerseits durch einen pn-Übergang (14) von der p-Basis (2) getrennt ist, und mit einem Teilbereich (15) des p-Emitters, der etwa unterhalb eines Zündkontakts (8) oder einer lichtempfindlichen Thyristorzone (17a) angeordnet ist und eine höhere Dotierungskonzentration aufweist als die übrigen Teile des p-Emitters (4),
**dadurch gekennzeichnet**,
daß ein unterhalb des Zündkontakts (8) oder der lichtempfindlichen Thyristorzone (17a) liegender, mit Elektronen oder Protonen bestrahlter Bereich (16) des Thyristors vorhanden ist.

2. Verfahren zur Herstellung eines Thyristors nach Anspruch 1,
**dadurch** **gekennzeichnet**,
daß ausgehend von einem dotierten Halbleiterkörper mit vier aufeinanderfolgenden Halbleiterschichten alternierender Leitfähigkeitstypen, die einen n-Emitter (1), eine p-Basis (2), eine n-Basis (3) und einen p-Emitter (4) darstellen, eine photolithographische Maske (23) auf der äußeren Grenzfläche (4a) des p-Emitters (4) aufgebracht und mit einem Fenster (24) versehen wird, daß durch dieses Fenster (24) in den p-Emitter (4) Akzeptorionen eingebracht werden, daß der Teilbereich (15) des p-Emitters (4) durch einen sich anschließenden Temperschritt gebildet wird, und daß ein unterhalb des Zündkontakts (8) oder der lichtempfindlichen Thyristorzone (17a) liegender Teilbereich (16) des Thyristors mit Elektronen oder Protonen bestrahlt wird.

3. Verfahren zur Herstellung eines Thyristors nach Anspruch 2,
**dadurch** **gekennzeichnet**,
daß er nach dem Bestrahlen des Teilbereichs (16) mit Elektronen oder Protonen einem weiteren Temperschritt unterworfen wird.

## Claims

1. Thyristor having a semiconductor body which exhibits an n-emitter (1) contacted by a cathode-side electrode (5) with an adjoining p-base (2) and a p-emitter (4) contacted by an anode-side electrode (6), with an adjoining n-base (3), which for its part is separated from the p-base (2) by a pn junction (14), and having a partial region (15) of the p-emitter which is disposed approximately below an ignition contact (8) or a light-sensitive thyristor zone (17a) and exhibits a higher doping concentration than the remaining parts of the p-emitter (4), characterized in that a region (16) of the thyristor, which region is situated below the ignition contact (8) or the light-sensitive thyristor zone (17a) and which is irradiated with electrons or protons, is present.

2. Process for the production of a thyristor according to Claim 1, characterized in that, proceeding from a doped semiconductor body with four successive semiconductor layers of alternating conductivity types, which represent an n-emitter (1), a p-base (2), an n-base (3) and a p-emitter (4), a photolithograhic mask (23) is applied to the outer boundary surface (4a) of the p-emitter (4) and is provided with a window (24), in that acceptor ions are introduced through this window (24) into the p-emitter (4), in that the partial region (15) of the p-emitter (4) is formed by a subsequent annealing step, and in that a partial region (16) of the thyristor, which partial region is situated below the ignition contact (8) or the light-sensitive-thyristor zone (17a), is irradiated with electrons or protons.

3. Process for the production of a thyristor according to Claim 2, characterized in that after the irradiation of the partial region (16) with electrons or protons it is subjected to a further annealing step.

## Revendications

1. Thyristor ayant un élément semiconducteur, qui comporte un émetteur (1) du type n, qui est en contact avec une électrode (5) de cathode et a une base (2) de type p voisine, et un émetteur (4) de type p, qui est en contact avec une électrode (6) d'anode et a une base (3) de type n voisine, laquelle est séparée pour sa part de la base (2) du type p par une jonction (14) pn, et ayant une zone (15) partielle de l'émetteur p, qui est disposée légèrement en-dessous d'un contact (8) d'amorçage ou d'une zone (17a) photosensible du thyristor et a une concentration en dopant plus grande que celle des autres parties de l'émetteur (4) de type p,
caractérisé en ce que
une zone (16) du thyristor, soumise à un faisceau d'électrons ou de protons se trouve sous le contact (8) d'amorçage ou sous la zone (17a) photosensible du thyristor.

2. Procédé de fabrication d'un thyristor suivant la revendication 1, caractérisé en ce que
en partant d'un élément semiconducteur dopé comportant quatre couches semiconductrices successives de type de conduction alternant, qui représentent un émetteur (1) de type n, une base (2) de type p, une base (3) de type n et un émetteur (4) de type p, on applique un masque (23) photolithographique sur la surface (4a) extérieure de l'émetteur (4) de type p et on ménage dans le masque une fenêtre (24), on introduit des ions accepteurs dans l'émetteur (4) de type p au travers de cette fenêtre (24), on forme la zone (15) partielle de l'émetteur (4) p lors d'une étape de recuit suivante, et on soumet une zone (16) partielle se trouvant sous le contact (8) d'amorçage ou sous la zone (17a) photosensible du thyristor à un faisceau d'électrons ou de protons.

3. Procédé de fabrication d'un thyristor suivant la revendication 2,
caractérisé en ce que
après que la zone (16) partielle ait été soumise à un faisceau d'électrons ou de protons, le thyristor est soumis à une autre étape de recuit.
